**Europäisches Patentamt**

(19) **European Patent Office**

**Office européen des brevets**

(11) Numéro de publication: **0 221 798**
**B1**

(12) # FASCICULE DE BREVET EUROPEEN

(45) Date de publication du fascicule du brevet:
06.12.89

(51) Int. Cl.⁴: **H01L 21/90**, H01L 23/52

(21) Numéro de dépôt: **86402138.1**

(22) Date de dépôt: **01.10.86**

(54) Procédé de formation d'un réseau métallique d'interconnexion des composants d'un circuit intégré de haute densité.

(30) Priorité: **03.10.85 FR 8514670**

(43) Date de publication de la demande:
**13.05.87 Bulletin 87/20**

(45) Mention de la délivrance du brevet:
**06.12.89 Bulletin 89/49**

(84) Etats contractants désignés:
**CH DE FR GB LI NL SE**

(56) Documents cités:
**EP-A- 0 025 261**
**EP-A- 0 071 010**
**EP-A- 0 147 203**
**EP-A- 0 223 637**
**US-A- 3 506 880**
**US-A- 3 542 550**

(73) Titulaire: **BULL S.A., 121 avenue de Malakoff P.B. 193.16,**
**F-75764 Paris Cédex 16(FR)**

(72) Inventeur: **Mérenda, Pierre Résidence Le Chambord,**
**G-102 Allée des écoles Val St. André,**
**F-13100 Aix-en-Provence(FR)**
Inventeur: **Lambert, Daniel, 31, rue du Vercors,**
**F-91200 Athis-Mons(FR)**
Inventeur: **Chantraine, Philippe, 27, rue Edmond Bloud,**
**F-92200- Neuilly Sur Seine(FR)**

(74) Mandataire: **Denis, Hervé et al, BULL S.A. Industrial**
**Property Department 25 avenue de la Grande-Armée,**
**F-75016 Paris(FR)**

ACTORUM AG

## Description

L'invention se rapporte à un procédé de formation d'un réseau métallique multicouche sensiblement plan sur un circuit intégré de haute densité, couramment appelé chip ou puce VLSI (Very Large Scale Integration).

Les procédés classiques de formation d'un réseau multicouche d'interconnexion des composants d'une puce consistent essentiellement à former une couche métallique sur une couche diélectrique recouvrant une couche métallique inférieure composée de conducteurs. Actuellement, les couches conductrices sont ordinairement en aluminium et ont une épaisseur de l'ordre du micromètre.

Initialement, la couche métallique inférieure a une épaisseur uniforme et recouvre une surface de base s'étalant au-dessus des composants de la puce. Les conducteurs sont ordinairement gravés en plaçant la couche métallique inférieure sous plasma réactif. Cette gravure est pratiquement anisotrope. Elle s'effectue dans le sens de l'épaisseur de la couche et donne ainsi aux conducteurs une section approximativement rectangulaire. A l'heure actuelle, le pas typique des conducteurs métalliques est de 6 micromètres (6 um) pour une largeur de 3 um, et il est souhaitable que ces dimensions puissent être abaissées.

La couche gravée est ensuite recouverte d'une couche diélectrique faite ordinairement par un dépôt chimique de dioxyde de silicium minéral (SiO2) en phase vapeur. L'épaisseur typique de cette couche est de l'ordre de 0,8 um. Il est souhaitable que la couche diélectrique ait une épaisseur uniforme sur toute la couche métallique inférieure pour assurer une isolation électrique satisfaisante et uniforme entre les deux couches métalliques.

Ensuite, on procède à la formation d'ouvertures de contact (vias) à travers la couche diélectrique pour l'interconnexion entre les conducteurs et la couche métallique supérieure. Celle-ci est disposée sur la couche diélectrique et dans ses ouvertures, puis elle est gravée pour former des conducteurs de manière analogue à ceux de la couche inférieure.

Cette technique pose actuellement de graves problèmes, préjudiciables à la densité désirée du réseau d'interconnexion et causés essentiellement par les fronts abrupts des conducteurs de la couche inférieure. En effet, au lieu d'obtenir une couche diélectrique d'épaisseur uniforme, l'expérience montre un retrait du diélectrique dans les angles que font les conducteurs avec leur surface de base dans un plan perpendiculaire aux conducteurs. Plus précisément, l'épaisseur de la couche diélectrique diminue progressivement vers le sommet de chaque angle de fond, approximativement tangentiellement à la bissectrice de l'angle. En elle-même, cette couche présente déjà l'inconvénient d'offrir dans les angles du fond une isolation défectueuse entre les couches métalliques.

Le dépôt de la couche conductrice supérieure sur la couche diélectrique pose en pratique un problème majeur, puisqu'il va évidemment amplifier considérablement les défauts de recouvrement de la couche diélectrique. Effectivement, l'expérience révèle un amincissement très prononcé de la couche conductrice, tangentiellement à la bissectrice des angles du fond. La couche métallique vue dans chaque angle du fond et dans un plan normal aux conducteurs prend ainsi la forme de deux lèvres adjacentes, tangentielles au plan bissecteur de l'angle du fond. L'amincissement présent à la jonction des lèvres crée une résistance électrique indésirable, que la couche accumule dans l'ensemble de ses angles de fond.

Cet inconvénient est encore aggravé lorsque la surface de base des conducteurs inférieurs n'est pas plane et qu'elle recouvre un relief analogue à angles droits. C'est le cas par exemple lorsque la couche conductrice inférieure est métallique et recouvre une autre couche conductrice, en silicium polycristallin ou métallique. Dans ce cas, deux conducteurs peuvent se superposer et créer un vallonnement plus accentué, qui va se répercuter par un amincissement plus étendu et plus accentué de la couche conductrice le long des parois verticales et, par conséquent, par une liaison électrique défectueuse avec la partie adjacente du fond. Dans tous les cas, les conducteurs de la couche supérieure vont ainsi présenter une suite de résistances appréciables dans tous ses angles de fond et poser des problèmes de fiabilité.

Une solution à tous ces problèmes a pour principe de rendre approximativement plane la surface de support de la couche métallique supérieure. Le brevet européen n° 0 025 261 se réfère à un procédé classique satisfaisant à ce principe. Ce procédé consiste, avant la formation de la couche métallique supérieure, à combler approximativement les creux présents dans les intervalles entre les conducteurs de la couche métallique inférieure, en étalant une suspension diélectrique visqueuse et en procédant au recuit de la suspension, puis à former une couche diélectrique classique, par dépôt chimique par exemple.

Plus précisément, le procédé commence par le dépôt de la suspension diélectrique sur l'ensemble de la couche métallique inférieure, avant formation de la couche diélectrique par dépôt chimique. La suspension remplit alors au moins partiellement les intervalles entre les conducteurs et, à cause de sa viscosité, elle s'étale sous forme d'un film mince sur les surfaces supérieures des conducteurs. Le recuit de la solution va déposer et fixer le diélectrique sous une forme moins compacte et de structure différente de celle de la couche diélectrique. Celle-ci est ordinairement formée par dépôt chimique en phase vapeur et recouvre uniformément le diélectrique de la suspension recuite. Bien entendu, elle peut être formée de toute autre manière. Cependant, une différence de nature entre les deux diélectriques soulève quelques difficultés pour la mise en œuvre de la solution envisagée.

D'une part, le diélectrique de la solution recuite présente ordinairement une résistance électrique moins élevée que le diélectrique déposé chimiquement. Sa plus faible isolation électrique limite le rapprochement souhaité des conducteurs entre eux. De fortes densités de conducteurs ne peuvent être obtenues qu'avec des suspensions spéciales ou dans des conditions particulières, nettement plus coûteuses.

D'autre part, pour relier les couches métalliques entre elles, des ouvertures de contact sont ménagées à travers la couche diélectrique et le film mince diélectrique qui recouvrent les conducteurs de la couche inférieure. Les ouvertures sont habituellement gravées par plasma réactif, qui présente une vitesse d'attaque plus élevée pour le diélectrique de la suspension recuite. La gravure normale créerait donc des flancs raides similaires à ceux des conducteurs et produirait le même phénomène de retrait de la couche métallique supérieure dans les angles du fond des ouvertures. Pour éviter le retrait, on a recours à une variante classique de la gravure, qui évase les ouvertures et rend ainsi leurs angles très obtus. Cependant, à cause de la superposition de la couche diélectrique au film diélectrique dans lesquels les vitesses d'attaque sont différentes, cette variante est difficile à maîtriser. Une surexposition s'avère ainsi nécessaire, qui amplifie l'effet de la composante latérale normalement faible de la gravure sous plasma réactif. Il en résulte un évasement différent dans le film et dans la couche, qui confère à chaque ouverture un profil en deux parties tronconiques coaxiales superposées. Cependant, la partie la plus évasée est relative au film et met par conséquent en surplomb les bords de la couche diélectrique supérieure. Un léger surplomb rend déjà difficile le dépôt de la couche métallique supérieure, par suite d'un phénomène de retrait analogue à celui présenté précédemment. Un surplomb relativement prononcé aboutit souvent à une coupure ou à une mauvaise continuité de la couche métallique supérieure au niveau des ouvertures. Pour pallier cet inconvénient, les ouvertures doivent être gravées selon un procédé très élaboré et plus coûteux.

En outre, avant de former la couche conductrice supérieure, il s'avère ordinairement indispensable de soumettre brièvement toute sa surface de support à une solution de nettoyage. Là encore, le diélectrique déposé chimiquement s'avère beaucoup plus résistant à l'attaque des solutions de nettoyage. En pratique, le film mince est suffisamment attaqué pour mettre en porte-à-faux les parties de la couche diélectrique avoisinant les ouvertures. Cela aggrave l'inconvénient précédent et s'oppose donc à la mise en œuvre des procédés classiques de formation de la couche métallique supérieure.

Pour pallier ces inconvénients du procédé classique, le brevet européen n° 0 025 261 décrit un procédé consistant à graver des conducteurs dans une couche métallique au moyen d'une couche de résine photorésistante, à laisser la couche de résine sur les conducteurs, à déposer et à recuire une suspension diélectrique visqueuse pour former une couche diélectrique uniforme, à chauffer à haute température le circuit intégré pour déformer la couche de résine et provoquer la séparation entre les parties de la couche diélectrique qui sont portées par la résine et les parties restantes comprises entre les conducteurs, à éliminer chimiquement la couche de résine et les parties de la couche diélectrique qui sont portées par la résine pour mettre à nu la face supérieure des conducteurs, à déposer sur les conducteurs et les parties restantes de la couche diélectrique une seconde couche diélectrique selon un procédé différent, et à ménager des ouvertures dans la seconde couche diélectrique, au-dessus des conducteurs.

Ce procédé, connu sous le nom de lift off, ajoute deux étapes délicates dans la fabrication du réseau d'interconnexion d'un circuit intégré. D'une part, l'exposition du circuit intégré à une haute température de l'ordre de 500°C peut être préjudiciable au bon fonctionnement des composants incorporés dans le circuit intégré. De plus, elle entraîne la décomposition de produits organiques contenus dans la résine, de sorte que des résidus se fixent sur les conducteurs. D'autre part, la séparation entre les parties de la première couche diélectrique qui sont portées par la résine et les parties restantes se fait selon un profil incontrôlable, qui peut introduire des fronts raides et créer les défauts précités dans la seconde couche diélectrique. En outre, ce procédé antérieur nécessite une élimination chimique de la couche de résine. Le solvant va donc entrer aussi en contact avec les parties restantes de la première couche diélectrique qui viennent d'être fortement chauffées. Enfin ce procédé rajoute une élimination par plasma d'oxygène des résidus de la couche de résine qui se sont fixés aux conducteurs.

La présente invention remédie aux inconvénients du procédé perfectionné décrit dans le brevet européen précité.

Selon l'invention, le procédé de formation d'un réseau métallique multicouche d'interconnexion des composants d'un circuit intégré de haute densité, consistant à former une couche métallique inférieure incluant des conducteurs à flancs raides, à recouvrir la couche métallique inférieure de deux couches diélectriques superposées, l'une étant obtenue par recuit d'une suspension diélectrique visqueuse et l'autre étant issue d'un procédé différent, à éliminer de la couche diélectrique obtenue par recuit toute l'épaisseur de parties situées au-dessus des conducteurs, à ménager des ouvertures dans ladite autre couche diélectrique au-dessus des conducteurs, et à former une couche métallique supérieure, est caractérisé en ce que l'élimination de la couche diélectrique obtenue par recuit se fait sur l'ensemble de cette couche selon ladite épaisseur des parties, indépendamment de l'ordre de formation des deux couches diélectriques.

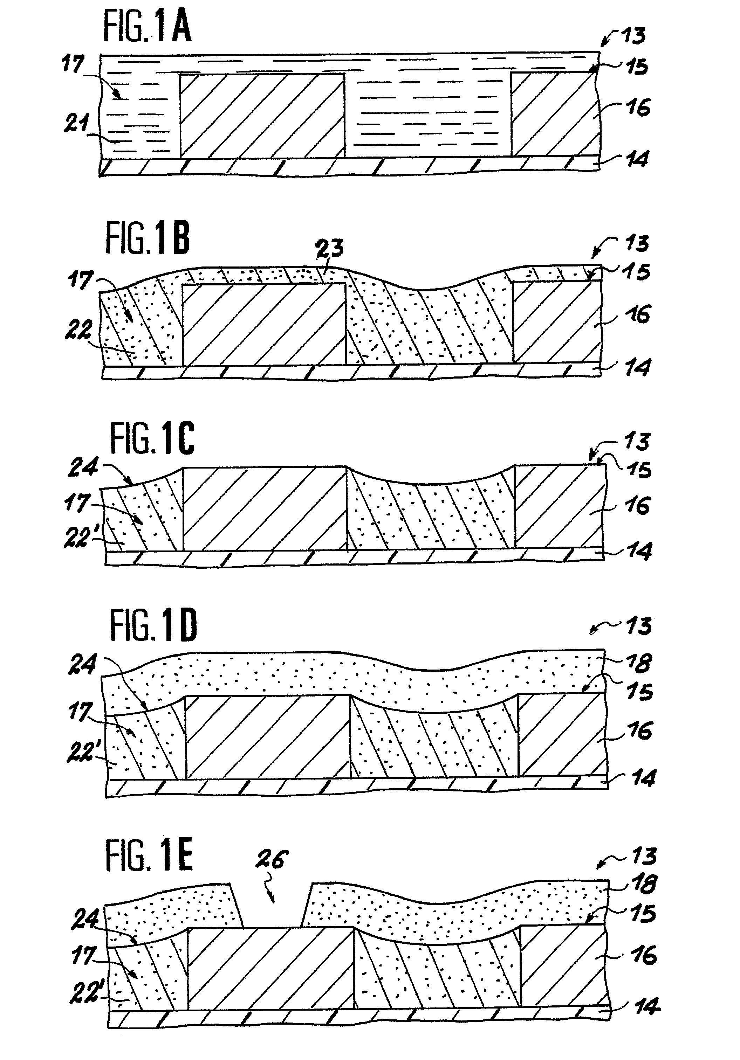

Les caractéristiques et avantages de l'invention ressortiront de la description qui suit, donnée à titre d'exemple et faite en référence aux figures 1A–1F des dessins annexés.

Les figures 1A–1F sont des vues en coupe transversale partielle d'un circuit intégré de haute densité, illustrant les étapes essentielles du procédé conforme à l'invention.

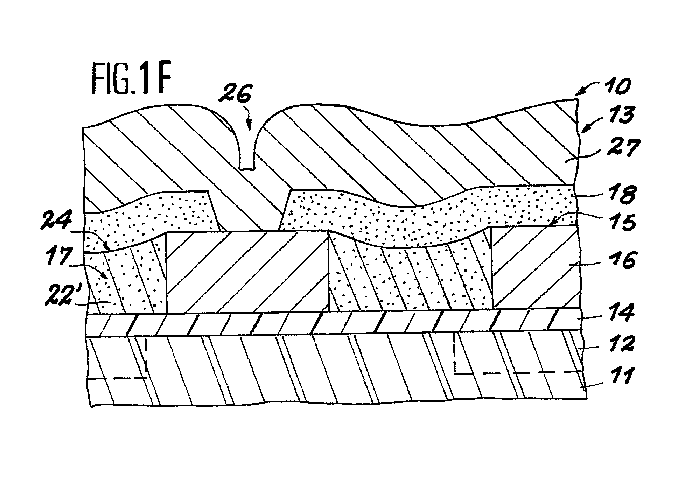

Un circuit intégré de haute densité (10) issu du procédé conforme à l'invention est représenté sur la figure 1F. Il se compose d'un substrat semiconducteur (11) incorporant un ensemble de composants (12) illustrés schématiquement, et un réseau métallique (13) pour l'interconnexion de composants (12) du substrat (11). Le réseau (13) a généralement comme surface de base la surface supérieure d'une couche d'isolation (14) recouvrant le substrat (11). En technologie MOS (Métal-Oxyde-Semiconducteur), le réseau métallique (13) recouvre souvent une couche primaire de conducteurs d'interconnexion en silicium polycristallin. Etant donné que les conducteurs polycristallins ne posent pas les problèmes résolus par l'invention, ces conducteurs ne sont pas représentés sur la figure 1, mais il est clair qu'un circuit intégré conforme à l'invention peut les incorporer. La description du réseau d'interconnexion (13) du circuit intégré (10) représenté sur figure 1 va maintenant être faite en suivant son procédé de fabrication illustré dans les figures 1A–1E.

En référence à la figure 1A, le réseau d'interconnexion (13) comprend d'abord, de manière classique, une couche conductrice inférieure (15) couvrant la face supérieure de la couche d'isolation (14). La couche (15) est composée de conducteurs métalliques (16) séparés par des intervalles (17). Les conducteurs (16) sont généralement parallèles entre eux, dans la direction perpendiculaire aux plans des figures illustrées, et présentent une section sensiblement rectangulaire. Cette section est due à la gravure sous plasma réactif d'une couche métallique initiale recouvrant uniformément la couche d'isolation (14). Certaines variantes de cette gravure permettent d'obtenir des fronts moins raides, qui posent néanmoins les mêmes problèmes que ceux à flancs verticaux. L'expression "conducteurs à flancs raides" doit donc être comprise comme englobant les conducteurs dont l'inclinaison des flancs pose les mêmes problèmes que ceux exposés précédemment et illustrés ci-après.

D'une manière générale, l'invention consiste d'abord à combler au moins partiellement les creux existant dans les intervalles (17) entre les conducteurs (16), de façon à donner à la couche métallique supérieure une surface de base grossièrement plane. Pour ce faire, une suspension diélectrique visqueuse (21) est déposée sur le circuit intégré (10), puis étalée de manière uniforme sur toute la surface de la couche conductrice (15). Dans la figure 1A, la suspension (21) a été mise en quantité suffisante pour déborder des intervalles (17) et former ainsi une nappe de surface uniform. L'étalement sera de préférence obtenu par la mise en rotation de la tranche semiconductrice (wafer) incluant le circuit intégré (10), à une vitesse déterminée de manière que la force centrifuge vienne en équilibre avec les forces de viscosité de la suspension. Par exemple, la suspension peut être un gel à base de silice avantageusement sous forme colloïdale, tel que celui appelé couramment S.O.G. (Spin-On-Glass) bien connu dans la technique. Dans ce cas, la suspension diélectrique s'utilise de la même manière que les résines photosensibles servant à la configuration des éléments du circuit intégré. En procédant ensuite au recuit de la suspension (21), le solvant de la suspension s'évapore tandis que le diélectrique forme une masse compacte (22) telle que représentée sur la figure 18. La masse (22) est essentiellement localisée dans les intervalles (17), mais recouvre aussi chaque conducteur (16) d'un film mince (23). Il est à noter que les films (23) existeront toujours, quel que soit le degré de remplissage des creux dans les intervalles (17), à cause de la viscosité de la suspension (21) et de son étalement. Dans la figure 1C, la masse diélectrique (22) toute entière a été mise sous plasma réactif pour éliminer uniformément une pellicule d'épaisseur correspondant sensiblement à l'épaisseur des films (23). Il en résulte une surface nouvelle (24) composée des surfaces supérieures mises à nu des conducteurs (16) et des surfaces supérieures de la masse diélectrique restante (22'). Comme le but est de mettre à nu les surfaces supérieures des conducteurs (16), la gravure sous plasma réactif peut n'être faite qu'à leur niveau. En effet, leur mise à nu permet d'y ménager des ouvertures de contact sans rencontrer deux variétés de diélectrique. Ensuite, dans la figure 1D, on recouvre la nouvelle surface (24) d'une couche diélectrique (18) d'épaisseur uniforme et de type classique, faite ordinairement en dioxyde de silicium déposé chimiquement en phase vapeur. L'avantage est d'avoir ainsi une épaisseur diélectrique homogène au-dessus des conducteurs (16), qui va faciliter la gravure des ouvertures de contact (26). Dans la figure 1E, les ouvertures de contact (26) sont ménagées au-dessus des conducteurs (16) pour leur connexion avec la couche métallique supérieure qui va être déposée ultérieurement. De manière classique, les ouvertures (26) sont aussi gravées sous plasma réactif. On observera que chaque ouverture (26) est maintenant formée d'une seule partie tronconique.

Le dépôt de la couche métallique supérieure (27) aboutit à la configuration représentée sur la figure 1F. Bien entendu, la couche (27) pourra ultérieurement servir de couche inférieure pour la mise en œuvre du procédé conforme à l'invention de formation d'un réseau d'interconnexion (13) à trois couches métalliques.

## Revendications

1. Procédé de formation d'un réseau métallique multicouche (13) sensiblement plan sur une circuit intégré de haute densité (10), consistant à former une couche métallique inférieure (15) incluant des conducteurs (16) à flancs raides, à former une première couche diélectrique (22) par recuit d'une suspension diélectrique visqueuse (21) étalée sur la couche métallique, comprenant des premières parties comblant au moins partiellement les intervalles (17) entre les conducteurs et des secondes parties (23) situées au-dessus des conducteurs, à éliminer les secondes parties de la première couche diélectrique, à former une seconde couche diélectrique (18) issue d'un procédé différent, à ménager des ouvertures (26) dans la seconde couche diélectrique au-dessus des conducteurs, et à former une couche métallique supérieure (27), caractérisé en ce que l'élimination des secondes parties de la première couche diélectrique est étendue uniformément de la même épaisseur sur l'ensemble des premières parties de cette couche.

2. Procédé selon la revendication 1, caractérisé en ce que l'élimination se fait par plasma réactif.

3. Procédé selon la revendication 1 ou 2, caractérisé en ce la suspension diélectrique (21) est un gel à base de silice, avantageusement sous forme colloïdale.

4. Procédé selon l'une des revendications 1 à 3, caractérisé en ce que la seconde couche diélectrique (18) est déposée chimiquement en phase vapeur.

5. Procédé selon la revendication 4, caractérisé en ce que le dépôt chimique en phase vapeur consiste en du dioxyde de silicium.

**Claims**

1. A method of forming a substantially flat multilayer metallic network (13) for a high-density integrated circuit (10), comprising forming a lower metal layer (15) including conductors (16) having steep sides, forming a first dielectric layer (22), by annealing a viscous dielectric suspension (21) spread over the metallic layer, comprising first portions at least partially filling the gaps (17) between the conductors and second portions (23) located above the conductors, removing the second portions of the first dielectric layer, forming a second dielectric layer (12) by a different method, making openings (26) in the second dielectric layer above the conductors (16) and forming an upper metallic layer (27), characterized in that the removal of the second portions of the first dielectric layer is extended uniformly to the same thickness over the entirety of the first portions of this layer.

2. A method according to claim 1, characterized in that the removal is effected by reactive plasma.

3. A method according to claim 1 or claim 2 characterized in that the dielectric suspension (21) is a silica-based gel, advantageously in colloidal form.

4. A method according to one of claims 1 to 3 characterized in that the second dielectric layer (18) is deposited chemically in the vapour phase.

5. A method according to claim 4 characterized in that the chemical vapour phase deposit consists of silicon dioxide.

**Patentansprüche**

1. Verfahren zur Herstellung eines mehrschichtigen metallischen Netzwerkes (13), das auf einer integrierten Schaltung (10) von hoher Dichte im wesentlichen eben liegt, welches darin besteht, eine untere metallische Schicht (15) zu bilden, die Leiter (16) mit steilen Flanken enthält, eine erste dielektrische Schicht (22) durch Brennen einer dickflüssigen, dielektrischen Suspension (21) zu bilden, welche auf die metallische Schicht verteilt wird und erste Teile umfaßt, die wenigstens teilweise die Zwischenräume (17) zwischen den Leitern ausfüllen, sowie zweite Teile (23) umfaßt, die über den Leitern angeordnet sind; die zweiten Teile der ersten dielektrischen Schicht zu entfernen; eine zweite dielektrische Schicht (18), die aus einem verschiedenen Verfahren stammt, zu bilden; Öffnungen (26) in der zweiten dielektrischen Schicht über den Leitern anzubringen, sowie eine obere metallische Schicht (27) zu bilden, dadurch gekennzeichnet, daß das Entfernen der zweiten Teile der ersten dielektrischen Schicht gleichmäßig um die selbe Dicke auf die Gesamtheit der ersten Teile dieser Schicht erstreckt wird.

2. Verfahren nach Anspruch 1, dadurch gekennzeichnet, daß das Entfernen durch reaktives Plasma erfolgt.

3. Verfahren nach Anspruch 1 oder 2, dadurch gekennzeichnet, daß die dielektrische Suspension (21) ein Gel auf Siliziumoxidbasis ist, vorzugsweise in kolloidaler Form.

4. Verfahren nach einem der Ansprüche 1 bis 3, dadurch gekennzeichnet, daß die zweite dielektrische Schicht (18) aus der Dampfphase chemisch aufgebracht wird.

5. Verfahren nach Anspruch 4, dadurch gekennzeichnet, daß der chemische Überzug aus der Dampfphase aus Siliziumdioxid besteht.

EP 0 221 798 B1

FIG.1A

FIG.1B

FIG.1C

FIG.1D

FIG.1E

FIG.1F